# EUROPEAN PATENT APPLICATION

(11) **EP 1 182 705 A1**
(43) Date of publication of application: **27.02.2002**
(21) Application number: 00966407.9
(22) Date of filing: 11.10.2000
(51) Int. Cl.: H01L 27/14, H01L 31/105

(54) **LIGHT-RECEIVING ELEMENT ARRAY AND LIGHT-RECEIVING ELEMENT ARRAY CHIP**

(30) Priority: 18.10.1999 JP 29492999; 12.11.1999 JP 32200999
(71) Applicant: Nippon Sheet Glass Co., Ltd., Osaka-shi, Osaka 541-0045 (JP)
(72) Inventor: KOMABA, Nobuyuki Nippon Sheet Glass Co., Ltd., Osaka-shi Osaka 541-0045 (JP); TAGAMI, Takashi Nippon Sheet Glass Co., Ltd., Osaka-shi Osaka 541-0045 (JP); KUSUDA, Yukihisa Nippon Sheet Glass Co., Ltd., Osaka-shi Osaka 541-0045 (JP); ARIMA, Yasunori Nippon Sheet Glass Co., Ltd., Osaka-shi Osaka 541-0045 (JP)
(74) Representative: Phillips, Patricia Marie
(86) International application number: JP0007047
(87) International publication number: WO0129896

(57) **Abstract**

A light-receiving element array is provided, in which a crosstalk between adjacent light-receiving elements may be decreased, and the size thereof may be small. The array is a mesa-type light-receiving element array in which the elements are isolated to each other by etched trenches. In this mesa-type light-receiving element array, an n-type InP layer, an i-type InGaAs layer (a light-absorbing layer), a p-type InP layer (a window layer) is stacked in this order on an n-type InP substrate. A part of InGaAs layer and InP layer are etched away to isolate the elements. The structure is coated by an insulating film. A p-type ohmic electrode is provided through a contact hole on the top of the p-type InP layer of each element, and a common n-type ohmic electrode is provided on the bottom of the n-type InP substrate.

## Description

### TECHNICAL FIELD

The present invention relates to a light-receiving element array, particularly to a light-receiving element array in which a crosstalk between light-receiving elements may be decreased. The present invention further relates to a light-receiving element array chip in which a chip size may be small.

### BACKGROUND ART

A light-receiving element array is used as a photodetector of an optical demultiplexer for demultiplexing the received wavelength multiplexed light beam every wavelength into a plurality of light beams, and monitoring the spectrum of each of the demultiplex light beams, for example in an optical communication system based on a wavelength multiplexed transmission.

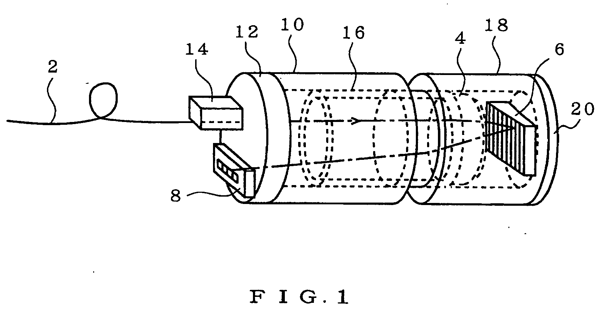

An example of an optical demultiplexer will now be described with reference to Fig.1. The optical demultiplexer comprises components such as an input optical fiber 2, a collimator lens 4, a diffraction grating 6, and a photodetector 8. These components are accommodated in three tubular members which are fitted to each other. The input optical fiber 2 consisted of a single core is fixedly coupled to a window 12 for fixing the fiber by means of a fiber coupling member 14, the window 12 being an end face of a transparent tube 10 for accommodating the fiber. The collimator lens 4 are fixed to an end of an intermediate tube 16. The diffraction grating 6 is fixed to an window 20, the window 20 being an end face of a tube 18 for accommodating the diffraction grating. In this optical demultiplexer, the tubes 10 and 18 are fitted to both ends of the intermediate tube 16 so as to be movable in the direction of light axis and rotatable around the light axis for active alignment.

The light beam from the input optical fiber 2 is guided into the optical demultiplexer. At this time, the light beam is diverged due to the numerical aperture of the fiber 2. The divergent beam reaches to the collimator lens 4 and is converged into parallel light beam by the collimator lens. The parallel light beam reaches to the diffraction grating 6 and is demodulated (or isolated) into a plurality light beams every wavelength by the wavelength dispersion characteristic of the diffraction grating 6. The demodulated light beams are converted into convergent light beams, respectively, by the collimator-lens 4. These convergent light beams impinge upon the window 12 which is positioned at a focal point of the collimator lens, and are arranged in one line on the window. The photodetection for each light beam may be possible, when the photodetector 8 is secured to the window 20 in such a manner that each light beam impinges correspondingly upon each light-receiving element of the photodetector 8.

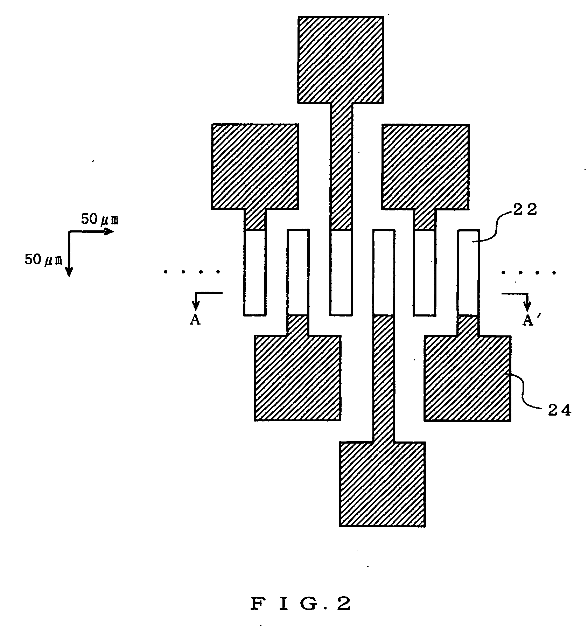

Fig.2 shows a commercially available light-receiving element array chip used in the light demultiplexer. The light-receiving element array chip comprises a light-receiving element array and bonding pads. The light-receiving element array consists of a plurality of light-receiving elements 22 arrayed in one line, and the electrodes of the light-receiving elements are alternately connected to the boding pads 24 arrayed on both sides of the light-receiving element array.

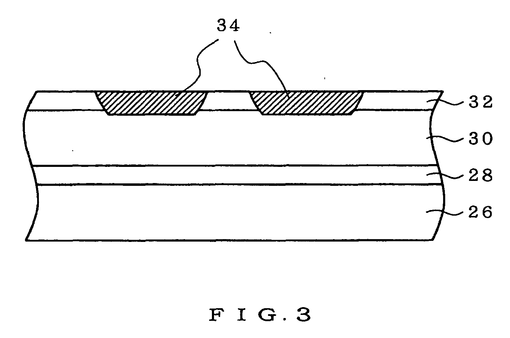

A light-receiving element constituting the conventional light-receiving element array chip is a pin-photodiode fabricated by a diffusion process. Fig.3 shows a partially enlarged cross-sectional view taken along A-A' line in Fig.2. An n-type InP layer 28, an i-type InGaAs layer (i.e., a light-absorbing layer) 30, and an n-type InP layer (i.e., a window layer) 32 are stacked in this order on an n-type InP substrate 26. Zn is diffused into the n-type InP layer 32 to form p-type regions 34 in order to fabricate pin-photodiodes. In this case, the Zn diffusion is isotropic and then proceeds in a lateral direction. The diffusion coefficient of InP is larger than that of InGaAs, so that the diffusion in a lateral direction is more promoted than that in a vertical direction. In this conventional diffusion-type light-receiving element array, therefore, it is limited to decrease the interval of the elements, e.g., the elements are arrayed in large pitch such as 50µm pitch. In Fig.2, the dimension of 50µm is designated by arrows.

The size of the bonding pad 24 is large such as 100µm× 100µm, so that the bonding pads are arrayed on both sides of the light-receiving element array, and on each side thereof they are arrayed in two rows as shown in the figure. Due to the presence of these bonding pads, the size of the chip becomes larger.

As described above, it is impossible to further narrow the interval of the light-receiving elements. Therefore, it is required that the optical path for the demultiplexed light beam is extended in the light demultiplexer, resulting in the limitation for miniaturization of the light demultiplexer.

In the conventional light-receiving element array chip, the size of the bonding pad is large as described above, so that the size of the chip may not be small. As a result, if the same number of pads as that of the light-receiving elements are arrayed, then the size of the chip becomes larger. Therefore, the conventional light-receiving element array is not suitable for a high density integration.

Also, the light-absorbing layers in the diffusion-type light-receiving element array are not isolated therebetween, so that the carriers generated by absorbed light may migrate to adjacent light-receiving elements by lateral diffusion, resulting in a crosstalk to the adjacent elements. As a result, the characteristic of the light-receiving element array is degraded.

### DISCLOSURE OF INVENTION

An object of the present invention is to provide a light-receiving element array in which a crosstalk between adjacent light-receiving elements may be decreased.

Another object of the present invention is to provide a light-receiving element array chip in which the size thereof may be small.

One problem in a conventional diffusion-type light-receiving element array is that the interval of elements is limited to decrease. This is because a pn-junction is formed by Zn diffusion. On the contrary, according to the present invention, a pn-junction is formed by doping p-type material while forming a window layer for a light-receiving element array, and a mesa-structure of light-receiving element array is fabricated by isolating the elements by means of an etching process. Accordingly, the size and array pitch of the light-receiving element array may be small.

Furthermore, the mesa-structure fabricated by forming a trench between the elements is adopted, so that the elements are independent to each other. As a result, the lateral diffusion of carriers is not caused in the light-receiving element array, and then a crosstalk between adjacent elements may be decreased.

Another problem in a conventional diffusion-type light-receiving element array is that the chip size is large. According to the present invention, the chip size may be small by adopting a matrix manner connection to decrease the number of bonding pads. Furthermore, the bonding pads may be arrayed on one side of the light-receiving element array.

A light-receiving element array chip adopting a matrix manner connection comprises a light-receiving element array consisting of a plurality of mesa-type light-receiving elements arrayed in one line; a plurality of first bonding pads, the plurality of mesa-type light-receiving elements being grouped into blocks every predetermined number of mesa-type light-receiving elements, one electrodes of the predetermined number of mesa-type light-receiving elements included in one of the blocks being connected together to one of the first bonding pads, and a plurality of second bonding pads the number thereof is equal to said predetermined number, the other electrodes of the mesa-type light-receiving elements being connected every other said predetermined number of elements to one of the second bonding pads.

### BRIEF DESCRIPTION OF DRAWINGS

Fig.1 is a schematic perspective view illustrating the structure of a light demultiplexer.
Fig.2 is a plan view of a conventional light-receiving element array chip.
Fig.3 is an enlarged cross-sectional view taken along A-A' line in Fig.2.
Fig.4 is a cross-sectional view of a mesa-type light-receiving element array of one embodiment according to the present invention.
Fig.5 is a cross-sectional view of a mesa-type light-receiving element array of another embodiment according to the present invention.
Fig.6 is a cross-sectional view of a mesa-type light-receiving element array of a further embodiment according to the present invention.
Fig.7 is a plan view of a light-receiving element array chip according to the present invention.
Fig.8 is a cross-sectional view taken along C-C' line in Fig.7.

### BEST MODE FOR CARRYING OUT THE INVENTION

### First Embodiment

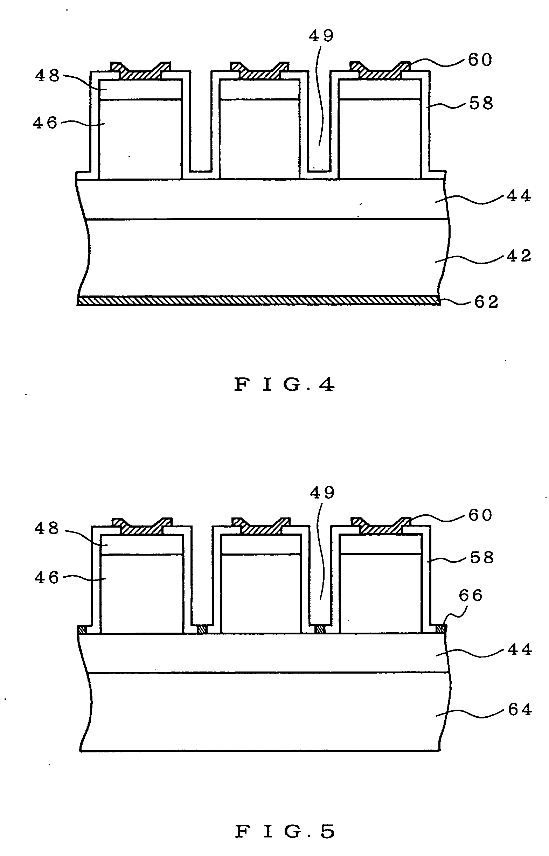

Fig.4 shows a cross-sectional view of a light-receiving element array of an embodiment according to the present invention. This array is a mesa-type light-receiving element array in which the elements are isolated to each other by etched trenches. In this mesa-type light-receiving element array, an n-type InP layer 44, an i-type InGaAs layer (a light-absorbing layer) 46, a p-type InP layer (a window layer) 48 is stacked in this order on an n-type InP substrate 42. A part of InGaAs layer 46 and InP layer 48 are etched away to isolate the elements. The structure is coated by an insulating film 58. A p-type ohmic electrode 60 is provided through a contact hole on the top of the p-type InP layer 48 of each element, and a common n-type ohmic electrode 62 is provided on the bottom of the n-type InP substrate 42.

The light-receiving element array described above is fabricated in the following manner. The n-type InP layer 44, the i-type InGaAs layer 46, and the p-type InP layer 48 are epitaxially grown in turn on the n-type InP substrate 42 by an MOCVD method and the like. At this time, the i-type InGaAs layer 46 may be undoped or slightly doped. Isolation trenches 49 are formed between the elements by etching a part of the InGaAs layer 46 and InP layer 48 down to the surface of the n-type InP layer 44 to fabricate a mesa-structure. In the fabrication of the mesa-structure, an etchant having a selectivity for InP and InGaAs is used to easily stop the etching at the interface of layers.

Next, an insulating film 58 consisting of SiN film is deposited on the topmost p-type InP layer 48 and on the surface of the n-type InP layer 44 exposed by an etching process. A contact hole is opened in the insulating film to form a p-type ohmic electrode 60 consisting of AuZn on the p-type InP layer 48, respectively. An n-type ohmic electrode 62 consisting of AuGeNi is formed on the bottom of the n-type InP substrate 42.

After the insulating film 58 is deposited, wirings including bonding pads are formed. At this time, the wirings may be used as ohmic electrodes. The thickness of the insulating film 58 on the top of the light-receiving element is selected such that the insulating film becomes nonreflective, so that the performance of the array may be enhanced.

Fig.5 shows another embodiment of the light-receiving element array using a semi-insulating (SI) InP substrate. On the semi-insulating InP substrate 64, the n-type InP layer 44, the i-type InGaAs layer 46, and the p-type InP layer 48 are epitaxially grown in turn in the same manner as the embodiment in Fig.4. Isolation trenches 49 are formed between the elements by etching a part of the InGaAs layer 46 and InP layer 48. The insulating film 58 is deposited, and a contact hole is opened in the insulating film to form the p-type ohmic electrode 60 on the p-type InP layer 48, respectively. A contact hole is opened in the insulating film 58 on the bottom of the isolating trench 49 to form an n-type electrode 66 for each light-receiving element.

According to the embodiments in Figs. 4 and 5, a pn-junction is formed by epitaxial growth, so that the size and the array pitch of the light-receiving element array may be small.

Also, the adjacent light-receiving elements are isolated with the trench, so that the lateral diffusion of the carriers is not caused. As a result, a crosstalk between the adjacent elements may be decreased.

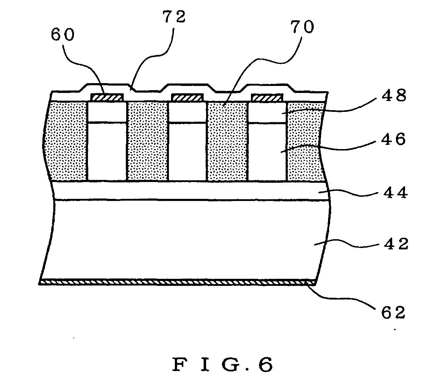

Fig.6 shows an embodiment of the light-receiving element array in which the trenches are buried or filled with a semiconductor material to decrease a leakage current in a pn-junction and to make a dark current of the element small. Semi-insulating InP or undoped InP may be used for the semiconductor material filled in the trenches.

The light-receiving element array is fabricated in the following manner. The n-type InP layer 44, the i-type InGaAs layer 46, and the p-type InP layer 48 are epitaxially grown in turn on the n-type InP substrate 42 by an MOCVD method and the like. At this time, the i-type InGaAs layer 46 may be undoped or slightly doped. Isolation trenches are formed between the elements by etching a part of the p-type InP layer and the i-type InGaAs layer down to the surface of the n-type InP layer. The area not being etched is coated by a masking film (not shown) such as SiN film, SiO₂ film, and the like, and then semi-insulating InP (e.g., Fe doped InP) or undoped InP is epitaxially grown only in the trenches. In the figure, the grown InP is designated by reference numeral 70. After the masking film is removed, the p-type ohmic electrode (AuZn) 60 is formed on the p-type InP layer 48 and the common n-type ohmic electrode (AuGeNi) 62 is formed on the bottom of the n-type InP substrate 42. An insulating film 72 is deposited on the structure, and then wirings (not shown) including bonding pads are formed.

In the embodiment of Fig.6, the wirings may be used as ohmic electrodes like in the embodiment of Fig.4. The thickness of the insulating film 72 is selected such that the insulating film becomes nonreflective, so that the performance of the array may be enhanced.

Also, according to the embodiment of Fig.6, the isolating trenches are buried by the semiconductor material, so that the etched surface of the mesa-structure may be improved and the recombination centers due to damages are decreased. As a result, a leakage current in the mesa-structure is decreased.

The isolation trenches are buried and planarized with the material epitaxially grown, so that the wirings may be easily formed on the structure.

The planarization is possible by burying the trenches with the epitaxially grown material, so that the depth of the trench may be large. As a result, the thickness of the light-absorbing film 46 may be increased. When the thickness of light-absorbing film is large, the characteristics such as a light-receiving sensitivity and a voltage resistance may be improved.

In the fabrication of the mesa-structure of the light-receiving element array according to the present invention, an etchant having a selectivity for InP and InGaAs is used, so that the etching may easily be stopped at the interface of layers. Also, the SiN film or SiO₂ film is used as a masking film during an etching process, so that the patterning of the masking film may be omitted.

In the embodiments illustrated in Figs. 4-6, the pin-structure is fabricated by growing in turn the n-type InP layer, the i-type InGaAs layer, and the p-type InP layer. However, the fabrication of the pin-structure is not limited to this, but the pin-structure may be fabricated by growing in turn the n-type InP layer, the i-type InGaAs layer and the n-type InP layer, and then a p-type impurity is diffused into the latter n-type InP layer. When the isolating trenches are formed in the pin-structure, the mesa-type light-receiving element array may be fabricated.

### Second Embodiment

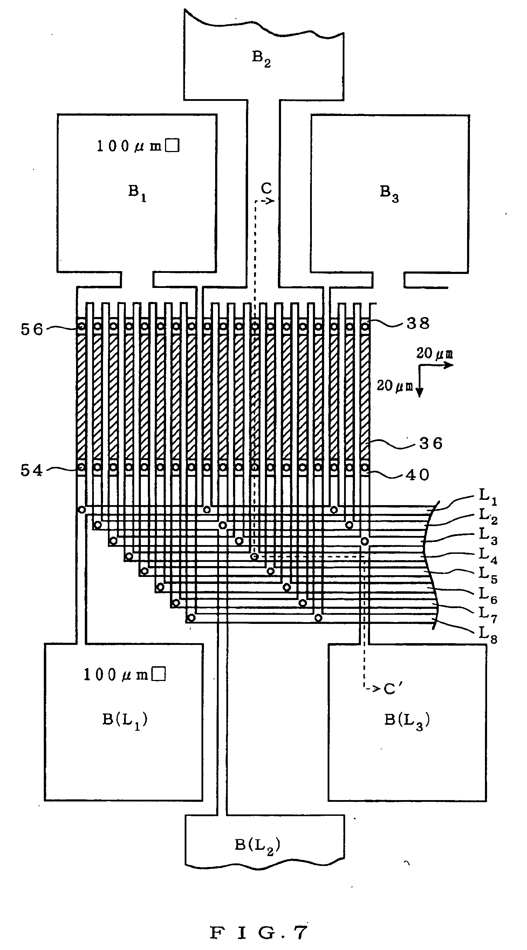

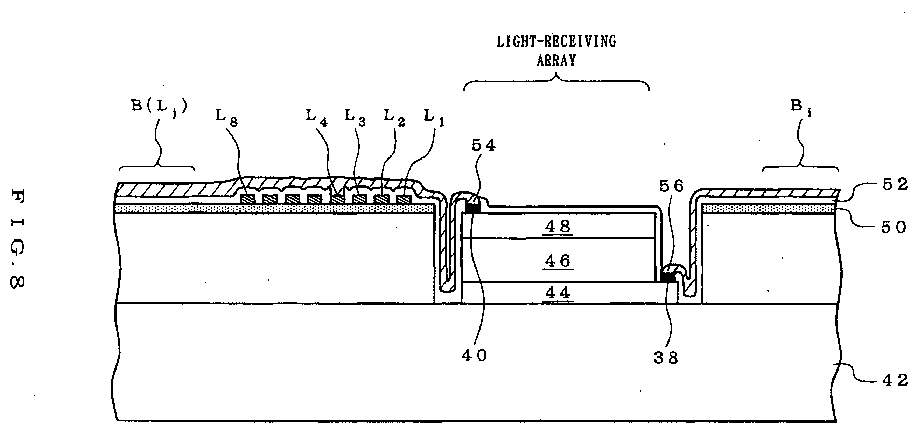

Fig.7 shows a plan view of a light-receiving element array chip in which a mesa-type light-receiving element array is used to make the size of a chip small. Fig.8 is a cross-sectional view taken along a polygonal line C-C' in Fig.7. The dimension of 20 µm is designated by arrows in Fig.7. The light-receiving element array is an array including mesa-type light-receiving elements 36 arrayed in 10 µm pitch, each element having a width of 6 µm. These light-receiving elements are grouped into blocks every eight elements. On one side of the light-receiving element array, two rows of bonding pads Bᵢ (each having a size of 100 µm×100 µm) are arrayed. If there are 128 elements, i is 1 to 16. The n-type electrodes 38 of the elements included in one block are connected together to one bonding pad, respectively. On the other hand, the p-type electrodes 40 of the elements are connected every other eight elements to the wirings Lⱼ(j=1 to 8). Each wiring Lⱼ is connected to one of eight bonding pads B(Lⱼ) arrayed in two rows on the other side of the light-receiving element array, each bonding pad having a size of 100 µm×100 µm. It should be noted that only three bonding pads B(L₁), B(L₂), and B(L₃) are shown in Fig.7. The connection for the light-receiving element array described above is referred to as a matrix manner connection herein.

The light-receiving element array chip including the matrix manner connection may be fabricated in a following manner. The n-type InP layer 44, the i-type InGaAs layer 46, and the p-type InP layer 48 are epitaxially grown in turn on the n-type InP substrate 42 by an MOCVD method and the like. At this time, the i-type InGaAs layer 46 may be undoped or slightly doped.

Next, a first etching process is proceeded to expose a part of the surface of the n-type InP layer 44. A second etching process is proceeded to etch a part of the n-type InP layer 44 down to the InP substrate 42 with remaining the area for electrodes. The elements are isolated by the second etching process to fabricate a mesa-type structure of light-receiving element array. In each element, the p-type ohmic electrode 40 is formed on the topmost p-type InP layer 48, and the n-type ohmic electrode 28 is formed on the area of the n-type InP layer 44 exposed by the second etching process.

Next, an insulating film 50 is deposited on the structure except the area of the light-receiving element array, and then the wirings L₁ - L₈ are formed on the insulating film. An interlayer insulating film 52 is deposited on all the surface including the area of the light-receiving element array. In each element, a contact hole 54 is opened in the interlayer insulating film on the p-type electrode 40, and a contact hole 56 is opened in the interlayer insulating film on the n-type electrode 38. Then, the bonding pads B(Lⱼ) and Bᵢ, and wirings are formed.

According to the light-receiving element array including the matrix manner connection described above, only the light-receiving element is made active, which is connected to both the bonding pads Bᵢ and B(Lⱼ) to which voltages are supplied.

In the embodiment illustrated in Figs. 7 and 8, two rows of bonding pads (100 µm×100 µm) are arrayed but one row of bonding pads may be arrayed if the size of bonding pads is smaller than the total width of eight light-receiving elements.

### INDUSTRIAL APPLICABILITY

According to the present invention, the light-receiving elements are electrically independent to each other by adopting the mesa-structure, so that a crosstalk between adjacent light-receiving elements may be decreased, as well as the size and array pitch may be small.

Also, according to the present invention, the matrix manner connection is adopted, so that it is unnecessary to provide one bonding pad to one light-receiving element. As a result, the number of bonding pads may be decreased and then the area occupied by the bonding pads may be small. Therefore, the size of a chip becomes smaller. Also, the bonding pads may be arrayed on one side of the light-receiving element array, because the number of bonding pads may be small.

Accordingly, a chip including a high density light-receiving element array for a light demultiplexer may be implemented, which consists of 128 light-receiving elements arrayed in pitch smaller than 25 µm, for example. At this time, the chip size is small, so that the number of chips obtained from one epitaxial wafer may be enhanced.

## Claims

1. A light-receiving element array wherein a plurality of light-receiving elements each consisting of a pin-photodiode are arrayed, said pin-photodiode comprising :
an n-type semiconductor substrate,
an n-type semiconductor layer, an i-type semiconductor layer, and a p-type semiconductor layer stacked in this order on the n-type semiconductor substrate, the i-type and p-type semiconductor layers being isolated by a trench from adjacent i-type and p-type semiconductor layers,
a p-type electrode provided on the top of the p-type semiconductor layer, and
a common n-type electrode provided on the bottom of the n-type semiconductor substrate.

2. A light-receiving element array wherein a plurality of light-receiving elements each consisting of a pin-photodiode are arrayed, said pin-photodiode comprising :
a semi-insulating substrate,
an n-type semiconductor layer, an i-type semiconductor layer, and a p-type semiconductor layer stacked in this order on the semi-insulating substrate, the i-type and p-type semiconductor layers being isolated by a trench from adjacent i-type and p-type semiconductor layers,
a p-type electrode provided on the top of the p-type semiconductor layer, and
an n-type electrode provided on the n-type semiconductor layer at the bottom of the trench.

3. The light-receiving element array according to claim 1 or 2, wherein the trench is buried with a semi-insulating material or undoped semiconductor material.

4. A light-receiving element array chip wherein a plurality of light-receiving elements are arrayed, comprising :
a light-receiving element array consisting of a plurality of mesa-type light-receiving element arrayed in one line,
a plurality of wirings for connecting the mesa-type light-receiving elements in a matrix manner, and
a plurality of bonding pads connected to the wirings.

5. A light-receiving element array chip wherein a plurality of light-receiving elements are arrayed, comprising :
a light-receiving element array consisting of a plurality of mesa-type light-receiving elements arrayed in one line,
a plurality of first bonding pads, the plurality of mesa-type light-receiving elements being grouped into blocks every predetermined number of mesa-type light-receiving elements, one electrodes of the predetermined number of mesa-type light-receiving elements included in one of the blocks being connected together to one of the first bonding pads, and
a plurality of second bonding pads the number thereof is equal to said predetermined number, the other electrodes of the mesa-type light-receiving elements being connected every other said predetermined number of elements to one of the second bonding pads.

6. The light-receiving element array chip according to claim 4 or 5, wherein each of the mesa-type light-receiving elements consists of a pin-photodiode.

7. The light-receiving element array according to claim 5, wherein only the mesa-type light-receiving element is made active, which is connected to the first and second electrodes to both thereof voltages are supplied.
